# DEMANDE DE BREVET EUROPEEN

(11) **EP 1 120 982 A1**
(43) Date de publication de la demande: **01.08.2001**
(21) Numéro de dépôt: 01400118.4
(22) Date de dépôt: 16.01.2001
(51) Int. Cl.: H04Q 7/32

(54) **Dispositif de réception de signaux radiophoniques et/ou télévisuels affranchi des contraintes géographiques et utilisation du dispositif**

(30) Priorité: 25.01.2000 FR 0001076
(71) Demandeur: SAGEM S.A., 75116 Paris (FR)
(72) Inventeur: Lodola, Patrick, 91330 Yerres (FR)
(74) Mandataire: Schmit, Christian Norbert Marie

(57) **Abrégé**

L'invention concerne un dispositif (20) susceptible de recevoir des signaux télévisuels ou radiophoniques, qui permet de s'affranchir de certaines contraintes de réglage : le dispositif selon l'invention comprend des moyens qui permettent de déterminer simplement, notamment lors du passage d'une région à une autre, des fréquences d'émissions utilisées par différents opérateurs. A cet effet, le dispositif selon l'invention comporte en outre un équipement terminal (27) capable de communiquer sur un réseau de radiotéléphonie cellulaire.

Application aux décodeurs de signaux de télévision.

## Description

La présente invention a pour objet un dispositif de réception de signaux radiophoniques et /ou télévisuels affranchi des contraintes géographiques. L'utilisation d'un tel dispositif de réception est également envisagée dans de nombreuses applications selon l'invention.

Les dispositifs concernés par l'invention sont essentiellement des appareils du type magnétoscopes, décodeurs, téléviseurs, postes de radio et tout autre appareil possédant des fonctions de réception, via des voies hertziennes ou satellites, de signaux dont les fréquences de fonctionnement peuvent dépendre d'une situation géographique. Par signaux radiophoniques ou télévisuels, on désigne l'ensemble des signaux émis par des opérateurs diffuseurs d'émissions de radio ou de télévision.

Un opérateur diffuseur d'émissions de radio ou de télévision est le plus souvent implanté sur une vaste étendue géographique. Cet opérateur ne peut pas couvrir l'ensemble de la zone où il est implanté au moyen d'un unique émetteur. En effet, pour des raisons de coût et pour limiter les perturbations électromagnétiques que généreraient des émetteurs trop puissants, la puissance des émetteurs disponibles est limitée. Un opérateur émet donc des signaux à partir d'un ensemble d'émetteurs répartis sur l'ensemble du territoire qu'il souhaite couvrir. Le territoire visé est ainsi découpé en plusieurs régions distinctes, ces différentes régions présentant inévitablement des zones de recouvrement. Une zone de recouvrement entre une première région R1 et une deuxième région R2 est une zone dans laquelle les signaux émis par l'opérateur peuvent être reçus à la fois depuis un émetteur de la région R1 et depuis un émetteur de la région R2.

Aussi, essentiellement pour éviter des phénomènes d'interférence d'ondes, des émetteurs appartenant à des régions adjacentes émettent sur des fréquences distinctes. En effet, le phénomène d'interférence d'ondes dans les zones de recouvrement peut considérablement nuire à la qualité des signaux reçus. Une des conséquences de la diversité des fréquences utilisées par un même opérateur, diffuseur d'émissions de radio ou de télévision via des voies hertziennes ou satellites, est la nécessité de régler les dispositifs de réception à chaque fois que l'on passe d'une région couverte par un premier émetteur à une autre région couverte par un deuxième émetteur. Il en résulte une difficulté d'initialisation et d'utilisation de ces appareils. Les réglages sont d'autant plus fastidieux à effectuer que le nombre de fréquences radio ou de chaînes de télévision est en perpétuelle augmentation. Par ailleurs, pour chaque opérateur, les fréquences utilisées dans les régions voisines de la région de réglage viennent perturber ce réglage, et le rendent encore plus complexe.

Le dispositif de réception de signaux radiophoniques ou télévisuels selon l'invention permet de pallier les problèmes qui viennent d'être décrits. En outre, le dispositif selon l'invention comprend des moyens pour rechercher d'une zone géographique à laquelle appartient le dispositif. Une fois la zone d'appartenance géographique définie, le dispositif selon l'invention met en oeuvre des moyens pour déterminer la fréquence utilisée par un opérateur dans la région contenant la zone géographique préalablement déterminée. Un microprocesseur controlant un ensemble de mémoires de programmes et de mémoires de données contenues dans le dispositif selon l'invention permet de gérer l'ensemble des opérations nécessaires. Pour atteindre ces objectifs, le dispositif de réception selon l'invention comprend notamment un équipement terminal d'un réseau de radiotéléphonie cellulaire, par exemple du type GSM (Global System for Mobile communication dans la littérature anglaise). Le dispositif de réception selon l'invention tire partie du fait que les systèmes de radiotéléphonie cellulaire ont un fonctionnement qui impose un découpage en zones distinctes de l'ensemble des territoires qu'il souhaite couvrir.

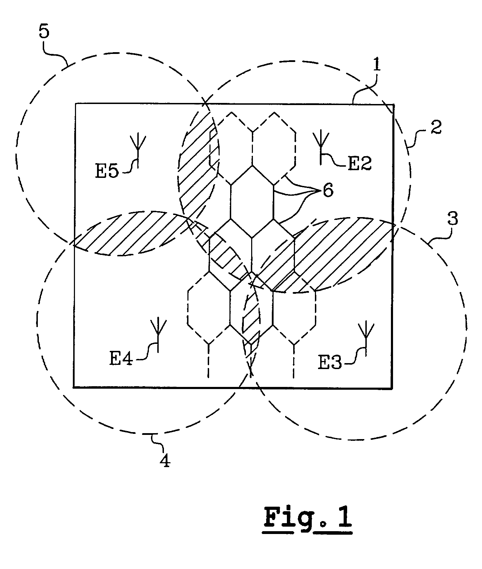

La figure **1** est une illustration du découpage en zones et régions d'une étendue géographique 1 pour assurer un fonctionnement optimal des systèmes d'émission de signaux radiophoniques ou télévisuels et des systèmes de radiotéléphonie cellulaire. L'étendue géographique rectangulaire 1 comprend quatre régions distinctes, numérotées de 2 à 5, chacune de ces régions est à peu près circulaire et comporte près de son centre un émetteur de signaux radiophoniques ou télévisuels, respectivement référencé E2 à E5. Les régions 2 à 5 sont toutes adjacentes les unes par rapport aux autres et présentent entre elles des zones de recouvrement hachurées sur la figure. Pour un opérateur donné, la fréquence d'émission de deux régions adjacentes est différente.

Par ailleurs, l'étendue géographique 1 est fractionnée en différentes zones représentées par des losanges 6 qui symbolisent la surface sur laquelle un terminal d'un réseau de radiotéléphonie cellulaire peut établir une liaison radio avec une station de base de ce système de radiotéléphonie cellulaire. Ces différentes zones s'appellent des cellules. Chaque cellule comporte une station de base de sorte que le terminal est toujours à moins de quelques kilomètres de l'une des stations de base. Un opérateur d'un système de radiotéléphonie cellulaire réalise une couverture d'une étendue géographique avec un ensemble de cellules continues. Pour économiser le spectre hertzien, les mêmes fréquences sont réutilisées sur des cellules suffisamment éloignées pour que deux communications qui utilisent la même fréquence ne se brouillent pas.

D'une façon générale, le découpage de l'étendue géographique par l'opérateur de radiotéléphonie cellulaire est plus fin que le découpage de la même étendue géographique par des opérateurs diffuseurs d'émissions de radio ou de télévision. Cependant, ce découpage n'est pas nécessairement régulier. En effet, le nombre de communications simultanées que peut écouler une station de base est limité notamment par le nombre de fréquences disponibles. Aussi, dans une zone urbaine qui présente par définition une forte densité de population, un opérateur utilise des microcellules de quelques centaines de mètres de largeur pour écouler un traffic important par unité de surface.

L'équipement terminal contenu dans le dispositif selon l'invention permet la détermination de la station de base dont le terminal dépend. Une station de base d'un système de radiotéléphonie cellulaire couvrant une zone géographique moins vaste qu'un diffuseur d'émissions radiophoniques ou télévisuelles, on peut déterminer la région couverte par ce dernier à laquelle appartient l'appareil de réception. Cette détermination peut être effectuée de façon automatique ou à la demande de l'utilisateur du dispositif selon l'invention. Des moyens de communication sont ensuite mis en oeuvre pour déterminer la ou les fréquences du ou des opérateurs dont on souhaite recevoir les émissions, et qui sont spécifiques à la région concernée.

L'invention concerne donc un dispositif de réception de signaux radiophoniques ou télévisuels, émis par différents opérateurs, comprenant un microprocesseur connecté au moyen d'un bus bidirectionnel de communication à une unité d'émission/réception, à une mémoire de programmes et à une mémoire de données, caractérisé en ce qu'il comporte un équipement terminal, connecté au bus bidirectionnel de communication, capable de communiquer sur un réseau de radiotéléphonie cellulaire. Le dispositif selon l'invention comprend en outre des moyens pour déterminer une zone géographique où il est situé, des moyens pour déterminer et mémoriser des fréquences de signaux télévisuels ou radiophoniques spécifiques à la zone géographique où est situé l'appareil.

Les différents aspects et avantages de l'invention apparaîtront plus clairement dans la suite de la description à l'examen des figures qui l'accompagnent et qui sont à présent introduites :
- la figure **1**, déjà décrite, est une illustration du découpage d'une étendue géographique en différentes cellules et régions correspondant à des zones de couverture de différents systèmes de communication mis en oeuvre sur cette étendue géographique ;
- la figure 2 est une représentation simplifiée de la structure interne du dispositif selon l'invention.

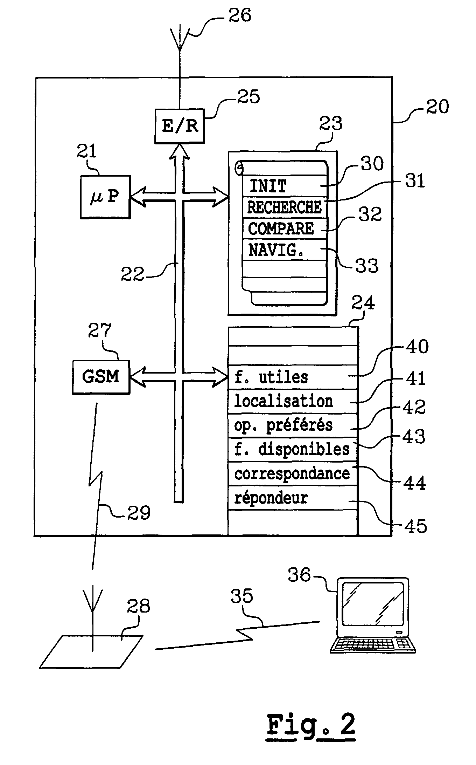

La structure interne d'un dispositif 20 selon l'invention, montrée à la figure 2, peut intégralement s'intégrer dans un décodeur de signaux de télévision. Cette structure comporte notamment un microprocesseur 21 qui est relié au moyen d'un bus bidirectionnel de communication 22 à une mémoire de programmes 23, à une mémoire de données 24 et à une unité d'émission/réception 25. L'unité d'émission/réception 25 assure notamment une sélection des fréquences à recevoir, cette sélection étant effectuée en fonction de réglages préalablement réalisés au sein du dispositif 20. Une antenne 26 reliée à l'unité d'émission/réception 25 permet de recevoir des signaux radiophoniques ou télévisuels.

Le bus bidirectionnel de communication 22 permet d'échanger des informations entre les différentes entités qui lui sont connectées. Ces informations peuvent être des signaux de commande émis par le microprocesseur vers les différentes entités qui lui sont connectées, des signaux d'adresse ou encore des signaux de donnés. La mémoire de programmes 23 peut contenir un ensemble d'algorithmes nécessaires au fonctionnement du dispositif 20. Par exemple, dans le cas où le dispositif 20 est un décodeur, la mémoire de programmes 23 renferme un ensemble d'algorithmes de décompression et de conversion de différents signaux susceptibles d'être reçus par l'unité d'émission/réception 25. Le microprocesseur 21 et les différents algorithmes de la mémoire de programmes 23 vont solliciter tout au long de leur mise en oeuvre différentes données contenues dans la mémoire de données 24.

Lorsque le possesseur du dispositif 20 utilise pour la première fois son appareil de réception, ou lorsqu'il réinsatalle le dispositif 20 dans une région où les opérateurs que le dispositif 20 est en mesure de recevoir émettent sur des fréquences différentes des fréquences utilisées dans la région où le dispositif était préalablement installé, un ensemble de mises au point de l'unité d'émission/réception 25 doivent être effectués. A cet effet, le dispositif 20 selon l'invention dispose d'un ensemble de moyens pour déterminer, dans une première étape, une zone géographique où est situé le dispositif. Ces moyens comprennent notamment un équipement terminal 27 capable de communiquer sur un réseau de radiotéléphonie cellulaire, une fonction d'initialisation 30 et une fonction de recherche 31.

Par ailleurs, le dispositif selon l'invention peut être utilisé comme un terminal de raccordement abonné. Un terminal de raccordement abonné est une borne mobile sur laquelle on peut connecter un téléphone fixe ou établir une liaison avec un portatif. La présence de l'équipement terminal 27 à l'intérieur du dispositif 20 permet cette utilisation. Elle peut être très avantageuse dans le cas où un opérateur de radiotéléphonie cellulaire propose un abonnement où l'utilisation d'un portatif bénéficie d'un coût réduit à proximité de l'équipement terminal, par exemple dans un secteur correspondant à l'intérieur d'un domicile, et un coût plus important dès que le portatif est utilisé à une distance plus importante de l'équipement terminal. Le fait d'insérer l'équipement terminal 27 dans un dispositif de réception tel que celui qui fait l'objet de l'invention offre une certaine garantie que l'utilisateur ne déplacera pas l'équipement terminal qui constitue la borne mobile . Le dispositif selon l'invention comporte donc des moyens d'interface pour servir de terminal de raccordement d'abonné en combinaison avec un téléphone fixe ou mobile.

Pour le reste, lors de la mise en service du dispositif 20, la fonction d'initialisation 30 contenue dans la mémoire de programmes 23 est mise en oeuvre de façon automatique ou suite à une requête de l'utilisateur. La fonction d'initialisation a pour tâche de vérifier un ensemble de paramètres du dispositif, et notamment de vérifier si des fréquences mémorisées dans une zone 40, dite de fréquences utiles, de la mémoire de données 24 ont été mises à jour, par exemple depuis la dernière mise sous tension du dispositif. Si cette mise à jour des fréquences utiles mémorisées n'a pas été effectuée, la fonction initialisation 30 active la fonction recherche 31 qui a va permettre de déterminer la zone géographique où est situé le dispositif 20.

A cette fin, la fonction recherche 31 active, via le bus de communication bidirectionnel 22, l'équipement terminal 27 qui établit une communication 29 avec le réseau de radiotéléphonie cellulaire auquel il appartient. La communication 29 ainsi établie passe nécessairement par une station de base 28 couvrant la cellule à laquelle appartient le dispositif 20. La station de base 28 est localisée suite à un échange de données sur des canaux spécifiques de signalisation du système cellulaire dits SMS (Short Message Service dans la littérature anglaise) ; ce type de canaux permet un échange d'informations binaires, pouvant atteindre jusqu'à 300 bits par seconde, entre un utilisateur du système de radiotéléphonie cellulaire et le réseau de radiotéléphonie cellulaire. Les informations relatives à la position de la station de base 28, et donc relatives à la zone géographique du dispositif 20, sont mémorisées dans une zone 41, dite de localisation, de la mémoire de données 34.

Le dispositif selon l'invention fait ensuite intervenir, dans une deuxième étape, des moyens pour recevoir et mémoriser des valeurs des fréquences des signaux télévisuels ou radiophoniques spécifiques à la zone géographique où est situé le dispositif. Dans une première application de l'invention, une communication 35 est établie sous forme d'une connexion internet entre le dispositif 20 et un site 36 d'un opérateur radiophonique ou télévisuel au moyen de l'équipement terminal 27. Les données relatives à la zone géographique à laquelle apparteint le dispositif 20, qui sont contenues dans la zone de localisation 31, sont ainsi transmises vers le site de l'opérateur, qui détermine automatiquement la région géographique correspondante, et envoie au dispositif 20 la valeur de la fréquence sur laquelle il émet dans cette région. Il faut noter que si la zone géographique où se situe le dispositif 20 est dans une zone de recouvrement de deux régions distinctes pour l'opérateur, le site de l'opérateur peut indifféremment transmettre une des deux valeurs de la fréquence d'émission.

La valeur de la fréquence est mémorisée dans la zone de fréquences utiles 40 de la mémoire de données 24. L'opération est répétée pour chaque opérateur susceptible d'émettre dans la zone où est situé le dispositif. L'utilisateur du dispositif peut également avoir préalablement déterminé et mémorisé, dans une zone 42, dite d'opérateurs préférés, de la mémoire de données 24, une liste d'opérateurs particuliers qui l'intéressent plus particulièrement, et qui seront les seuls à faire des opérations de détermination et de mémorisation de fréquence qui viennent d'être décrites. Les fréquences des émissions des chaînes radiophoniques ou télévisuelles sont ainsi récupérées et mémorisées dans la mémoire de données 24.

Afin de limiter les échanges de données sur la liaison Internet, une deuxième application de l'invention est proposée pour déterminer et mémoriser des fréquences de signaux télévisuels ou radiophoniques. Dans cette deuxième application de l'invention, une connexion internet est établie entre le dispositif 20 et un site spécialisé qui, à partir des seules données relatives à la zone géographique à laquelle apparteint le dispositif 20, qui sont contenues dans la zone de localisation 41, envoie l'ensemble des valeurs des fréquences disponibles dans la région correspondante. Ces valeurs sont mémorisées dans une zone 43, dite de fréquences disponibles, de la mémoire de données 24. Dans les deux applications qui viennent d'être décrites, une éventuelle comparaison avec la liste d'opérateurs préétablie par l'utilisateur, contenue dans la zone d'opérateurs préférés 42, peut être effectuée, au moyen d'une fonction de comparaison 32 de la mémoire de programmes 23. Ainsi, on détermine à partir de la liste d'opérateurs particuliers, les fréquences à mémoriser dans la zone de fréquences utiles 40.

Dans une version perfectionnée de l'invention, une zone 44, dite de correspondance, de la mémoire de données 24 est réservée pour une table de correspondance qui établit automatiquement une relation entre une information relative à la localisation de la station de base et l'ensemble des fréquences disponibles d'émission d'opérateurs radiophoniques ou télévisuels. Ainsi, à partir des seules données relatives à la zone géographique à laquelle apparteint le dispositif 20, le site de chaque opérateur ou le site spécialisé retourne au dispositif, via la liaison internet établie, un signal binaire simple qui est une information relative à la région à laquelle le dispositif appartient ; la table de correspondance établit alors automatiquement la fréquence ou l'ensemble des fréquences utiles. Dans cette version perfectionnée de l'invention, l'utilisateur du dispositif 20 peut une nouvelle fois avoir préalablement effectué une sélection d'opérateurs spécifiques dans la zone d'opérateurs préférés 42, une confrontation entre la liste des opérateurs préférés et les opérateurs donnés par la table de correspondance pouvant être effectuée par la fonction de comparaison 32 afin de ne mémoriser que les fréquences utiles souhaitées .

L'ensemble des moyens, intervenant au sein du dispositif 20 pour recevoir et mémoriser des fréquences de signaux télévisuels ou radiophoniques spécifiques à la zone géographique où est situé le dispositif, et qui viennent d'être décrits, peuvent être mis en oeuvre de façon automatique, par exemple lors de la mise sous tension du dispositif, ou sur requête d'un utilisateur du dispositif.

Afin d'informer l'utilisateur sur les différentes opérations de détermination et de mémorisation des fréquences, le dispositif selon l'invention peut comprendre des moyens pour visualiser ces opérations. Il peut notamment visualiser des informations relatives aux fréquences mémorisées

Le dispositif selon l'invention, du fait de la présence de l'équipement terminal, peut être utilisé pour diverses applications : par exemple, le dispositif selon l'invention peut être utilisé comme répondeur téléphonique si un numéro de téléphone est attribué à l'équipement terminal. Une personne appelant au numéro de téléphone attribué a la possibilité de laisser un message qui est mémorisé dans une zone spécifique 45, dite de répondeur, de la mémoire de données 24.

Une liaison Internet pouvant également être établie via l'équipement terminal 27, le dispositif selon l'invention peut aussi être utilisé comme une messagerie internet s'il est relié à des périphériques clavier et écran. Les fonctions de navigation sur le réseau internet sont également rendues possibles en équipant la mémoire de programmes 23 d'une fonction logicielle appropriée 33. Cette possibilité permet au dispositif selon l'invention d'envisager des opérations du type télépaiement.

Enfin, la présence de l'équipement terminal à l'intérieur du dispositif selon l'invention peut présenter un aspect sécuritaire dans le cas où le dispositif serait dérobé : les canaux de signalisation du système cellulaire dits SMS permettent en effet d'établir une communication entre le réseau de radiotéléphonie cellulaire et l'équipement terminal, et de localiser approximativement le dispositif. La localisation est d'autant plus précise que les cellules du réseau sont petites.

## Revendications

1. Dispositif (20) susceptible de recevoir des signaux télévisuels ou radiophoniques, émis par différents opérateurs, comprenant un microprocesseur (21) connecté au moyen d'un bus bidirectionnel de communication (22) à une unité d'émission/réception (25), à une mémoire de programmes (23) et à une mémoire de données (24), caractérisé en ce qu'il comporte un équipement terminal (27), connecté au bus bidirectionnel de communication, capable de communiquer sur un réseau de radiotéléphonie cellulaire.

2. Dispositif (20) selon la revendication 1 caractérisé en ce qu'il comprend des moyens (20 ;31) pour déterminer, à l'aide de l'équipement terminal (27) capable de communiquer sur un réseau de radiotéléphonie cellulaire, une zone géographique où est situé le dispositif.

3. Dispositif (20) selon la revendication 2 caractérisé en ce qu'il comprend des moyens pour recevoir et mémoriser des valeurs de fréquences de signaux télévisuels ou radiophoniques spécifiques à la zone géographique où est situé le dispositif.

4. Dispositif (20) selon la revendication 3 caractérisé en ce que les moyens pour recevoir et mémoriser des fréquences de signaux télévisuels ou radiophoniques spécifiques à la zone géographique où est situé le dispositif sont mis en oeuvre de façon automatique.

5. Dispositif (20) selon la revendication 3 caractérisé en ce que les moyens pour recevoir et mémoriser des fréquences de signaux télévisuels spécifiques à la zone géographique où est situé le dispositif sont mis en oeuvre sur requête d'un utilisateur du dispositif.

6. Dispositif (20) selon l'une des revendications 3 à 5 caractérisé en ce que les moyens pour recevoir et mémoriser des fréquences de signaux télévisuels ou radiophoniques spécifiques à la zone géographique où est situé le dispositif comprennent l'équipement terminal (27), pour établir une communication (35) entre le dispositif (20) et un site (36) d'un opérateur, et une zone de fréquences utiles (40) de la mémoire de données (24) pour mémoriser une valeur de la fréquence de l'opérateur dans la zone géographique où est situé l'opérateur.

7. Dispositif (20) selon la revendication 6 caractérisé en ce que la mémoire de données (24) comporte une zone (42) d'opératuers préférés pour déterminer une liste d'opérateurs particuliers qui seront seuls à être mémorisés dans la zone de fréquences utiles (40).

8. Dispositif (20) selon la revendication 7 caractérisé en ce que la mémoire de programmes (23) comprend une fonction de comparaison (32) pour déterminer, à partir de la liste d'opérateurs particuliers, les fréquences à mémoriser dans la zone de fréquences utiles (40) de la mémoire de données (24).

9. Dispositif (20) selon l'une des revendications 6 à 8 caractérisé en ce qu'il comprend une table de correspondance mémorisée dans une zone de correspondance (44) de la mémoire de données (24) pour établir automatiquement une relation entre une information relative à la localisation de la station de base et un ensemble de fréquences disponibles.

10. Dispositif (20) selon l'une des revendications 3 à 9 caractérisé en ce qu'il comprend des moyens pour visualiser des informations relatives aux fréquences mémorisées.

11. Dispositif (20) selon l'une des revendications précédentes caractérisé en ce qu'il comporte des moyens d'interface pour servir de terminal de raccordement abonné en combinaison avec un téléphone fixe ou mobile.

12. Dispositif (20) selon l'une des revendications précédentes caractérisé en ce que la mémoire de données (24) comporte une zone spécifique (45) pour mémoriser des appels téléphoniques.

13. Dispositif (20) selon l'une des revendications précédentes caractérisé en ce que ledit dispositif est un décodeur de signaux télévisés.

14. Utilisation du dispositif (20) selon l'une des revendications précédentes pour effectuer des opérations de télépaiement.

15. Utilisation du dispositif (20) selon l'une des revendications précédentes pour établir une liaison internet.
